# EUROPEAN PATENT APPLICATION

(11) **EP 4 621 854 A1**
(43) Date of publication of application: **24.09.2025**
(21) Application number: 23891924.5
(22) Date of filing: 10.11.2023
(51) Int. Cl.: H01L 31/18, H01L 23/00

(54) **SOLDERING DEVICE AND TABBING APPARATUS COMPRISING SAME**

(30) Priority: 14.11.2022 KR 20220151518
(71) Applicant: Hanwha Solutions Corporation, Seoul 04541 (KR)
(72) Inventor: JUNG, Min Kyo, Seoul 04541 (KR); CHUNG, Dong Jin, Seoul 04541 (KR); JEON, Sung Gyu, Seoul 04541 (KR)
(74) Representative: Mooser, Sebastian Thomas
(86) International application number: PCT/KR2023/018050
(87) International publication number: WO 2024/106857

(57) **Abstract**

The present invention relates to a soldering device and a tabbing apparatus comprising same. The soldering device comprises: a stage for supporting a solar cell and a wire; a body facing the stage; and a plurality of heaters positioned on the bottom surface of the body so as to face the solar cell and the wire, wherein the stage includes a first cooling part positioned in a region corresponding to the bottom surfaces of the solar cell and wire loaded thereon.

## Description

### [Technical Field]

The present invention relates to a soldering device and a tabbing apparatus including the same.

### [Background Art]

A solar cell is formed by arranging p-n junction diodes on a substrate. When a solar cell is irradiated with sunlight, excitons, which are electron-hole pairs, are generated, and as the excitons divide, the electrons move to an n layer, the holes move to a p layer, and thus photovoltaic power is generated at a p-n junction portion. A tabbing process is a process of arranging wires on a plurality of solar cells and electrically connecting the plurality of solar cells to form a single solar cell module.

A tabbing apparatus is a joining apparatus for connecting a plurality of solar cells and includes a soldering device. A soldering device melts solder on wires while the wires are arranged on the solar cells, thereby electrically connecting the solar cells and the wires. This soldering process necessarily includes a cooling process to cool the molten solder, but tabbing apparatuses of the related art perform natural cooling at room temperature without a separate cooling structure, and thus cooling takes a long time.

### [Disclosure]

### [Technical Problem]

The present invention is directed to providing a soldering device including a structure for cooling solar cells and wires coated with solder, and a tabbing apparatus including the same.

### [Technical Solution]

A soldering device includes: a stage that supports a solar cell and a wire; a body that faces the stage; and a plurality of heaters that are positioned on a bottom surface of the body to face the solar cell and the wire, wherein the stage includes a first cooling unit positioned in a region corresponding to bottom surfaces of the solar cell and wire mounted on the stage.

When the plurality of heaters irradiate the solar cell and wire mounted on the stage with light, the stage may emit air from the first cooling unit at a position at which the stage faces the plurality of heaters or at a position at which the stage does not overlap the plurality of heaters to cool the solar cell and the wire.

The first cooling unit may include: a lower air inlet; a first lower panel that has a flow path through which air is introduced from the lower air inlet; and a second lower panel that has a top surface on which the solar cell and the wire are mounted, an air distribution flow path communicating with the flow path of the first lower panel, and a plurality of air nozzles communicating with the air distribution flow path and emitting air toward the solar cell and the wire.

The first cooling unit may be positioned with the same number and interval to correspond to a plurality of wires mounted on the stage.

The soldering device may further include a second cooling unit that is positioned on the bottom surface of the body and emits air toward the solar cell and wire mounted on the stage.

The second cooling unit may include: an upper air inlet; a first upper panel having a flow path through which air is introduced from the upper air inlet; and a second upper panel that is positioned on a bottom surface of the first upper panel and includes a plurality of air nozzles communicating with the flow path.

The plurality of air nozzles may be positioned alternately with the plurality of heaters in one direction.

The first upper panel may include: a pair of air supply ports corresponding to the upper air inlet; an air distribution flow path that is formed on the bottom surface of the first upper panel and communicates with the pair of air supply ports; and a plurality of air distribution slits that extend from the air distribution flow path and overlap the plurality of air nozzles of the second upper panel.

A plurality of air nozzles provided in the first cooling unit and a plurality of air nozzles provided in the second cooling unit may be spaced apart from each other in different directions.

A tabbing apparatus includes: a solar cell supply device that supplies a solar cell; a wire transport device that is spaced apart from the solar cell supply device and supplies a plurality of wires; a wire jig transport device that is spaced apart from the solar cell supply device and the wire transport device and supplies a wire jig which supports the solar cell and the wires; a moving device that supplies the solar cell and the wire jig onto the wires arranged on the wire transport device; and a soldering device that allows the solar cell and the wire jig to be mounted on the wires and then solders the solar cell and the wires, wherein the soldering device is the soldering device according to any one of claims 1 to 9.

The tabbing apparatus may further include a dipping unit that coats or plates the plurality of wires with solder and supplies the wires to the wire transport device.

### [Advantageous Effects]

Since a soldering device and a tabbing apparatus including the same melt solder on a solar cell and a wire and then emit air to cool the solder, the time required for a tabbing process can be reduced.

Since a soldering device and a tabbing apparatus including the same emit air toward bottom surfaces of a solar cell and a wire using a first cooling unit provided in a stage that supports the solar cell and the wire, it is possible to efficiently cool the solar cell and the wire.

Since a soldering device and a tabbing apparatus including the same emit air toward top surfaces of a solar cell and a wire using a second cooling unit in addition to a first cooling unit, it is possible to efficiently cool the solar cell and the wire.

### [Description of Drawings]

FIG. 1 is a schematic view of a tabbing apparatus.
FIG. 2 shows a state of connecting solar cells and wires.
FIG. 3 shows a soldering process of a soldering device.
FIG. 4 shows a stage of the soldering device.
FIG. 5 shows a first cooling unit of the stage.
FIG. 6 shows a body.
FIG. 7 shows a bottom surface of a second cooling unit.
FIG. 8 shows the second cooling unit.
FIG. 9 is an exploded perspective view of bottom surfaces of a first upper panel and a second upper panel.

### [Best Modes of the Invention]

A soldering device includes: a stage that supports a solar cell and a wire; a body that faces the stage; and a plurality of heaters that are positioned on a bottom surface of the body to face the solar cell and the wire, wherein the stage includes a first cooling unit positioned in a region corresponding to bottom surfaces of the solar cell and wire mounted on the stage.

### [Modes of the Invention]

Hereinafter, the present disclosure will be described with reference to embodiments illustrated in the attached drawings. Embodiments of the present disclosure are not limited to those described in this specification and may have different forms. Therefore, the embodiments will be described below with reference to the drawings to describe aspects and features of the present invention.

The present disclosure includes various embodiments and modified examples, and specific embodiments thereof are illustrated in the drawings and described below. However, the present disclosure is not limited to the embodiments and includes all modifications, equivalents, or substitutes included in the spirit and scope of the present invention.

When an element or layer is referred to as being "above" another element or layer, or "connected" or "coupled" to another element or layer, the element or layer may be directly connected or coupled to the other element or layer. Alternatively, one or more elements or layers may be additionally present therebetween. When an element or layer is referred to as being "directly above," "directly connected to," or "directly coupled to" another element or layer, no other intermediate elements or layers may be present therebetween. For example, when a first element is described as being "coupled" or "connected" to a second element, the first element may be directly coupled or connected to the second element, or the first element may be indirectly coupled or connected to the second element through one or more intermediate elements.

Dimensions of various elements, layers, etc., in the drawings may be exaggerated for clarity of illustration. The same reference numeral may represent the same element. As used in this specification, the term "and/or" includes any and all combinations of one or more of associated listed items. Additionally, when describing embodiments of the present invention, the use of "may" relates to "one or more embodiments of the present invention." Expressions such as "at least one" and "any one," when followed by a list of elements, may modify the entire list of elements but not individual elements of the list. For example, the expression "at least one of a, b, or c" may represent only a, only b, only c, both a and b, both a and c, both b and c, all of a, b, and c, or variations thereof. As used in this specification, the terms "use," "using," and "used" may be considered synonymous with the terms "utilize," "utilizing," and "utilized," respectively. As used in this specification, the terms "substantially," "about," and "similar" are used as terms of approximation rather than as terms of degree and are intended to describe the inherent variation in measured or calculated values that will be recognized by those skilled in the art.

In this specification, although the terms "first," "second," "third," etc., may be used to describe various elements, components, regions, layers, and/or sections, these elements, components, regions, layers, and/or sections should not be limited by these terms. These terms are used to distinguish one element, component, region, layer, or section from another element, component, region, layer, or section. Accordingly, a first element, a first component, a first region, a first layer, or a first section to be described below may be referred to as a second element, a second component, a second region, a second layer, or a second section without departing from the disclosure of the exemplary embodiments.

Spatially relative terms such as "below," "lower," "above," "upper," etc., may be used in this specification for convenience of description to describe a relationship of one element to another element (other elements), a feature of one element to a feature (features) of another element (other elements), or a function (functions) depicted in the drawings. The spatially relative terms may include other directions of the device in use or operation in addition to directions depicted in the drawings. For example, when a device in a drawing is turned over, an element described as "below" or "on a lower portion of" another element or feature may then be oriented "above" or "on an upper portion of" the other element or feature. Therefore, the term "below" can include both upward and downward directions. The device may be oriented in other directions (rotated 90 degrees or oriented in another direction) and the spatially relative terms used in this specification should be interpreted accordingly.

Terms used in this specification are used only to describe embodiments of the present invention and are not intended to limit the present invention. As used in this specification, a singular form may include a plural form unless the context clearly indicates otherwise. The terms "comprise," "have," and "include" specify a feature, an integer, a step, an operation, an element, and/or a component clearly stated when used in this specification, and do not exclude the presence or addition of one or more other functions, integers, steps, operations, elements, components, and/or groups thereof.

In the case of an embodiment that can be implemented in a process, a specific process sequence may be performed in a sequence other than that described. For example, two processes described sequentially may be performed simultaneously or substantially simultaneously or may be performed in reverse order from that described.

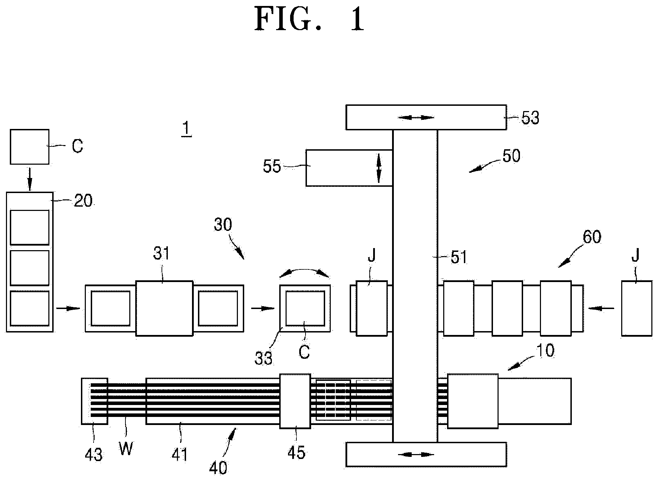

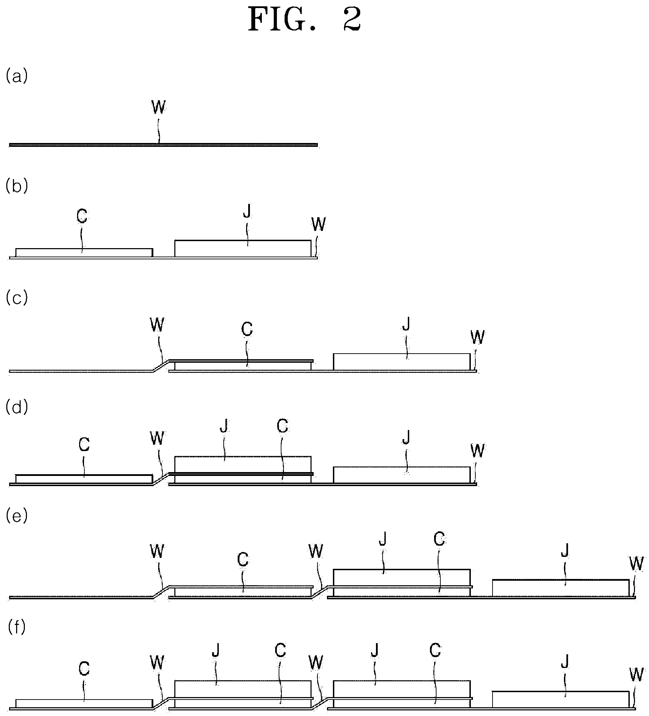

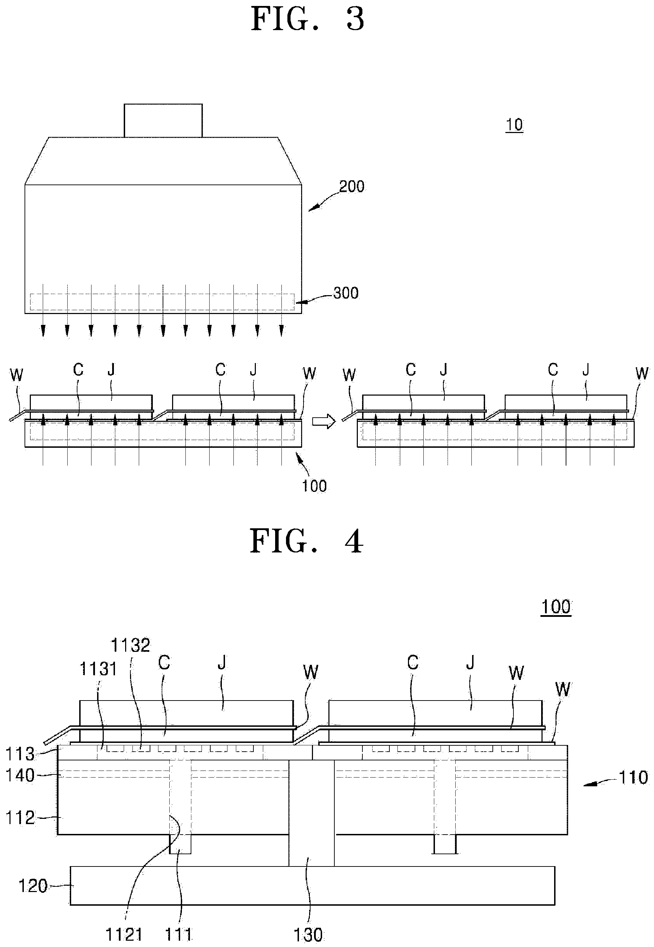

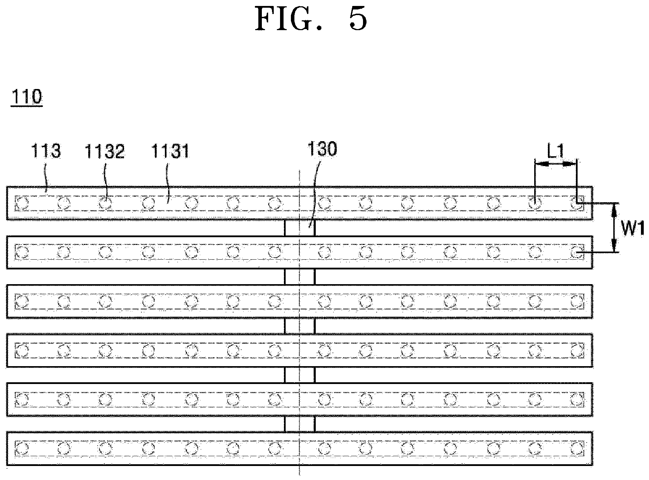

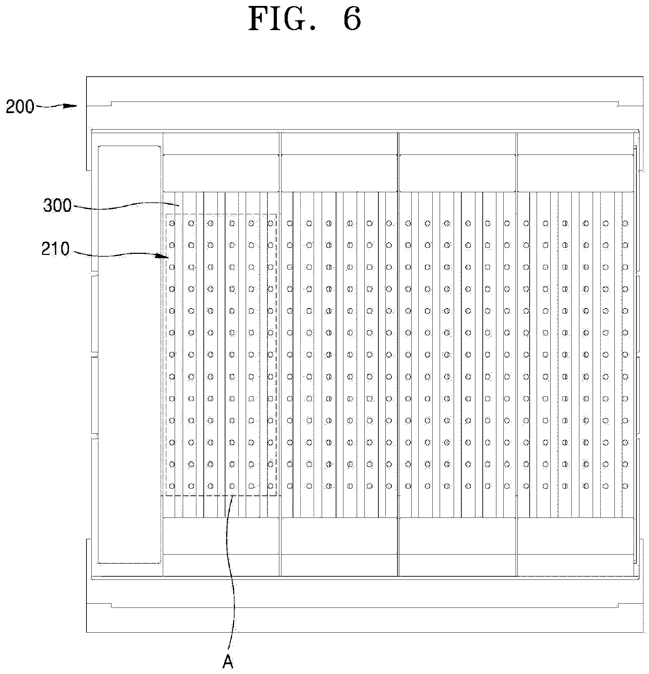

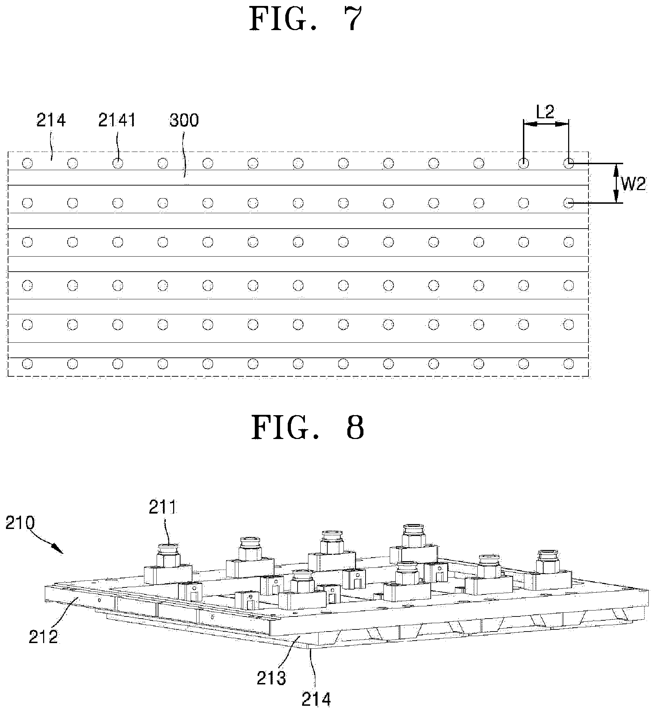

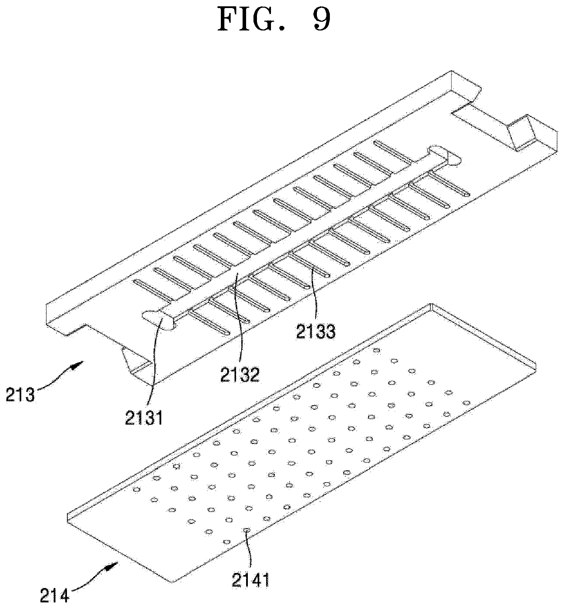

FIG. 1 is schematic view of a tabbing apparatus 1, FIG. 2 shows a state of connecting solar cells C and wires W, FIG. 3 shows a soldering process of a soldering device 10, FIG. 4 shows a stage 100 of the soldering device 10, FIG. 5 shows a first cooling unit 110 of the stage 100, FIG. 6 shows a body 200, and FIG. 7 shows a bottom surface of a second cooling unit 210 and is an enlarged view of portion A of FIG. 6. FIG. 8 shows the second cooling unit 210, and FIG. 9 is an exploded perspective view of bottom surfaces of a first upper panel 213 and a second upper panel 214.

The tabbing apparatus 1 is a device for connecting solar cells C and wires W to form a solar cell module. The solar cell C has a semiconductor junction region having a p-n junction surface, and when a certain amount of energy or more is applied thereto, an electromotive force is generated to convert light energy into electrical energy. A material of a semiconductor included in the solar cell C is not particularly limited, and silicon (single crystalline, polycrystalline, or amorphous silicon), gallium arsenide, cadmium tellurium, cadmium sulfide, indium phosphide, copper indium gallium selenide (CIGS), an organic dye, or a mixture thereof may be used.

The wires W are conductors for electrically connecting a plurality of solar cells C and connect the front surfaces of and rear surfaces of neighboring solar cells C. For example, the wires W may be electrically connected to the solar cells C through a soldering process. Alternatively, the wires W may be electrically connected to the solar cells C with an electrically conductive adhesive (ECA).

A wire jig J holds the wires W such that the wires W do not float or deviate from designated positions when the solar cells C and the wires W are connected. For example, as shown in FIG. 1, in a state in which the wires W are arranged on a wire transport device 40, the wire jig J may be mounted on the wire transport device 40 to press the wires W. Additionally, the wire jig J may be supported and transported by a moving device 50 which will be described below.

For example, as shown in FIG. 1, the tabbing apparatus 1 may include a soldering device 10, a solar cell transport device 20, a solar cell supply device 30, a wire transport device 40, a moving device 50, and a wire jig transport device 60.

The soldering device 10 is located to perform an end process of the tabbing apparatus 1 and connects the wires W and the solar cells C to form a solar cell module. For example, the soldering device 10 may melt solder while the solar cells C are mounted on the wires W and then cool the solder to electrically connect the solar cells C and the wires W. The soldering device 10 will be described below.

The solar cell transport device 20 is positioned on one side of the tabbing apparatus 1 and transports the solar cells C to the solar cell supply device 30. For example, as shown in FIG. 1, the solar cell transport device 20 may receive the solar cells C from the outside or pick up the solar cells C loaded in a magazine or the like and transport the solar cells C to the solar cell supply device 30. For example, the solar cell transport device 20 may be a conveyor for transporting the solar cells C in one direction. In addition, FIG. 1 shows that there is one solar cell transport device 20, but the present invention is not limited thereto. The number of the solar cell transport devices 20 may be two or more.

The solar cell supply device 30 divides the solar cell C received from the solar cell transport device 20 to correspond to a proper size and transports the divided solar cells C to the moving device 50. For example, the solar cell supply device 30 may include a scriber 31 and a stage 33.

The scriber 31 divides the solar cell C received from the solar cell transport device 20 into solar cells C to correspond to a size appropriate for the solar cell module. For example, the scriber 31 may irradiate a top surface of the solar cell C with a laser and then split the solar cell C into a plurality of solar cells C using a breaking device.

The stage 33 moves to a pre-designated position while supporting the divided solar cells C such that the moving device 50 may support the solar cells C. The stage 33 may move in directions of three axes including an X-axis, a Y-axis, and a Z-axis and rotates about a Z-axis to correct positions of the solar cells C. Additionally, the stage 33 may support the wire jig J in addition to the solar cells C. That is, the wire jig J transported by the wire jig transport device 60 which will be described below is mounted on the stage 33, and the moving device 50 may support the solar cells C and the wire jig J and mount the solar cells C and the wire jig J on the wires W.

The wire transport device 40 may be spaced apart from the solar cell supply device 30. The wire transport device 40 may transport the plurality of wires W. For example, the wire transport device 40 is a conveyor belt that extends in a direction perpendicular to a movement direction of a cell-jig transport unit 55 and may transport the plurality of wires W (for example, six or more). The wires W may be spaced a predetermined interval from each other. In this case, a soldering material, for example, solder, may be applied or plated on the wires W to be supplied to the wire transport device 40. For example, the embodiment may further include a dipping unit (not shown) for coating or plating the wires W with a soldering material, and the wires W passing through the dipping unit may be supplied to the wire transport device 40. For example, the wire transport device 40 stops for a moment when the cell-jig transport unit 55 moves the solar cells C and the wire jig J toward the wires W to allow the solar cells C and the wire jig J to be mounted on the wires W. Then, the wire transport device 40 may be operated again to transport the wires W.

The moving device 50 moves the solar cells C and the wire jig J to the wires W. For example, as shown in FIG. 1, the moving device 50 may be positioned across the wire transport device 40 and the wire jig transport device 60. That is, the moving device 50 may overlap the wire transport device 40 and the wire jig transport device 60 in a plan view. Additionally, the moving device 50 may include a first support 51, second supports 53, and the cell-jig transport unit 55 that moves along the first support 51.

The first support 51 is a frame that extends longitudinally across the wire jig transport device 60 and the wire transport device 40, and both ends of the first support 51 may be connected to the second supports 53. The second supports 53 may extend in a direction intersecting with the first support 51, and the first support 51 may adjust a position of the cell-jig transport unit 55 while moving in a longitudinal direction of the second supports 53.

The cell-jig transport unit 55 may move in a longitudinal direction of the first support 51, support the solar cells C and the wire jig J, and mount the solar cells C and the wire jig J on the wires W. For example, the cell-jig transport unit 55 may support the solar cells C and wire jig J mounted on the stage 33 simultaneously or separately. In addition, the cell-jig transport unit 55 may mount the supported solar cells C and wire jig J on the wires W mounted on the wire transport device 40.

The wire jig transport device 60 may be spaced apart from the solar cell supply device 40 and the wire transport device 50. The wire jig transport device 60 receives the wire jig J and transports the wire jig J to the moving device 50. The wire jig transport device 60 moves a plurality of wire jigs J toward the stage 33 and stops the wire jigs J at an end portion adjacent to the stage 33. In this state, a transfer device (not shown) may transfer the wire jig J onto the stage 33.

Referring to FIGS. 1 and 2, a tabbing process will be described using the tabbing apparatus 1 with wires W, a solar cell C, and a wire jig J.

First, when wires W are supplied by the wire transport device 40 (see FIG. 2A), the moving device 50 mounts a pair of a solar cell C and a wire jig J on the wires W (see FIG. 2B). Then, the wire transport device 40 mounts other wires W on the solar cell C (see FIG. 2C), and the moving device 50 mounts a pair of a solar cell C and a wire jig J on the other wires W (see FIG. 2D). In addition, the wire transport device 40 mounts other wires W on the solar cell C (see FIG. 2E), and the moving device 50 mounts another pair of a solar cell C and a wire jig J on the other wires W (see FIG. 2F). As a result, the solar cells C and the wires W may be electrically connected, and the wire jig J may support the wires W until the soldering process to prevent the wires W from being deviated from a designated position.

The soldering device 10 may heat the solar cells C and the wires W. For example, the soldering device 10 may heat the solder on a surface of the wires W up to a temperature for melting the solder. Accordingly, the wires W and the solar cell C may be thermally joined by the molten solder and physically and electrically connected.

Referring to FIGS. 3 to 9, the soldering device 10 may include a stage 100, a body 200, and a heater 300.

The stage 100 supports the solar cells C and the wires W. For example, the stage 100 receives the solar cells C, the wires W, and the wire jigs J, which support the solar cells C and the wires W, from the wire transport device 40 and supports the solar cells C, the wires W, and the wire jigs J. Here, the solar cells C, wires W, and wire jigs J mounted on the stage 100, may have a form shown in FIG. 2. Additionally, the stage 100 may support the solar cells C and the wires W and move the solar cells C and the wires W to designated positions.

For example, the stage 100 may be in the form of a conveyor. For example, the stage 100 may be a part of the conveyor of the wire transport device 40 or a separate conveyor connected to the conveyor of the wire transport device 40.

In another embodiment, the stage 100 may be independently moved. For example, the stage 100 is a shuttle-type transfer device and may transfer the solar cells C and the wires W while reciprocating between an end portion of the wire transport device 40 and a discharge position. For example, the stage 100 may move to the wire transport device 40 to receive the solar cells C and the wires W and move to a position corresponding to the body 200 for the soldering process. After the soldering process is completed, the stage 100 may be moved to the discharge position.

For example, the stage 100 may cool the solder melted during the soldering process, the solar cells C, and the wires W. For example, as shown in FIG. 3, after the solder is melted on the solar cells C and the wires W, the stage 100 may cool the solar cells C and the wires W at a position below the body 200. Alternatively, as shown in FIG. 3, the stage 100 may be moved to a position at which the stage 100 does not overlap the body 200 and then cool the molten solder, the solar cells C, and the wires W. Accordingly, the time required for cooling the molten solder naturally can be reduced.

For example, the stage 100 may include a first cooling unit 110. The first cooling unit 110 may emit air to the solar cells C and the wires W, on which the solder is melted, to cool the solar cells C and the wires W. For example, when a plurality of heaters 300 irradiate the solar cells C and wires W mounted on the stage 100 with light or apply heat to the solar cells C and wires W to melt the applied solder, the first cooling unit 110 may emit air at a position at which the stage 100 faces the plurality of heaters 300 to cool the molten solder, the solar cells C, and the wires W. Alternatively, in a state in which the stage 100 is moved to a position at which the stage 100 does not overlap the plurality of heaters 300, the first cooling unit 110 may emit air to cool the molten solder, the solar cells C, and the wires W.

For example, the first cooling unit 110 may spray air toward bottom surfaces of the solar cells C and wires W mounted on the stage 100. For example, the first cooling unit 110 may support the solar cells C and the wires W and emit air toward the bottom surfaces of the solar cells C and the wires W to cool the solar cells C and the wires W.

For example, the first cooling unit 110 may include a lower air inlet 111, a first lower panel 112, and a second lower panel 113.

The lower air inlet 111 is positioned on a bottom surface of the first cooling unit 110 and may supply cooling air. For example, as shown in FIG. 4, the lower air inlet 111 is positioned on the bottom surface of the first cooling unit 110 to overlap the center of the first cooling unit 110 and may be connected to an air supply source (not shown). The lower air inlet 111 may be connected to an air distribution flow path 1131 through an air supply flow path 1121 provided in the first lower panel 112.

The lower air inlet 111 is positioned on a bottom surface of the first lower panel 112, and first lower panel 112 has therein the air supply flow path 1121 communicating with the lower air inlet 111. One end of the air supply flow path 1121 may communicate with the lower air inlet 111 and the other end may communicate with the air distribution flow path 1131. Accordingly, the air introduced into the lower air inlet 111 from the air supply source may be introduced into the air distribution flow path 1131 through the air supply flow path 1121 and emitted toward the solar cells C and the wires W through an air nozzle 1132.

For example, the number of the first lower panels 112 may be the same as that of the wires W. For example, when the number of the wires W corresponding to one solar cell C is six, the number of the first lower panels 112 may be six. Each of the first lower panels 112 may have an independent air supply flow path 1121, and the lower air inlet 111 may be provided to correspond to each air supply flow path 1121. Accordingly, the first lower panels 112 may selectively and independently emit air at positions corresponding to the plurality of wires W to cool the solder, the solar cells C, and the wires W.

The second lower panel 113 may directly support the solar cells C and the wires W and may be positioned on the first lower panel 112. For example, as shown in FIG. 4, the second lower panel 113 may be positioned on the first lower panel 112 and support the wires W, solar cells C, and wire jigs J sequentially stacked in a height direction. The second lower panel 113 may emit air toward the wires W and the solar cells C to cool the molten solder.

For example, the second lower panel 113 may include the air distribution flow path 1131 and the air nozzle 1132. As shown in FIG. 4, the air distribution flow path 1131 may extend in a longitudinal direction of the second lower panel 113 and may be positioned inside the second lower panel 113. Additionally, the air distribution flow path 1131 may communicate with the air supply flow path 1121.

A plurality of air nozzles 1132 may be positioned on a top surface of the second lower panel 113 and communicate with the air distribution flow path 1131. The plurality of air nozzles 1132 may be spaced apart from each other in the longitudinal direction of the second lower panel 113. Accordingly, when air is supplied from the air supply source, air introduced along the air distribution flow path 1131 is emitted through the plurality of air nozzles 1132 to cool the molten solder, the solar cells C, and the wires W.

For example, the number of the second lower panels 113 may be the same as that of the wires W. For example, when the number of the wires W corresponding to one solar cell C is six, the number of the second lower panels 113 may be six. Each of the second lower panels 113 may have an independent air distribution flow path 1131 and independent air nozzles 1132 and may be connected to the air supply flow path 1121 of each first lower panel 112. Accordingly, the second lower panels 113 may selectively and independently emit air at positions corresponding to the plurality of wires W to cool the molten solder, the solar cells C, and the wires W.

For example, as shown in FIG. 5, a plurality of second lower panels 113 may be spaced apart from each other in one direction (e.g., in a direction perpendicular to a direction of movement of the solar cells C and the wires W). The plurality of second lower panels 113 may be spaced an interval W1 from each other, and the interval between the second lower panels 113 may be the same. Here, the interval W1 is an interval between the wires W, and the wires W may be arranged on each second lower panel 113. That is, the second lower panels 113 have the same number and interval as the plurality of wires W for the solar cell C, thereby efficiently cooling the solder, the solar cells C and the wires W.

For example, the plurality of air nozzles 1132 may be spaced an interval L1 from each other. The interval L1 may vary depending on a length of the solar cell C. For example, the interval L1 may be in the range of 5% to 15% of the length of the solar cell C (in the direction of movement of the solar cells C and the wires W). When the interval L1 is less than 5% of the length of the solar cell C, the number of the air nozzles 1132 becomes too great, and thus the pressure of the air emitted from the air nozzles 1132 may be insufficient and interference may occur between adjacent air nozzles 1132. In addition, when the interval L1 exceeds 15% of the length of the solar cell C, the interval between the air nozzles 1132 becomes too great, and thus it is difficult to uniformly cool the solder, the solar cells C, and the wires W.

Additionally, the number of the air nozzles 1132 is not particularly limited. For example, as shown in FIG. 5, two or more, particularly seven or more, air nozzles 1132 may be provided on one side centered on a support frame 130.

For example, the air nozzle 1132 may have a diameter greater than a width of the wire W to efficiently cool the molten solder.

For example, the stage 100 may include a main frame 120 and a support frame 130.

As shown in FIG. 4, the main frame 120 is positioned below the first cooling unit 110 and supports other components of the stage 100. The support frame 130 is positioned on the main frame 120 and connects the first cooling unit 110 to the main frame 120. For example, the support frame 130 is positioned on the center of the stage 100, extends in a width direction, and has a bottom surface positioned on the main frame 120 and a top surface capable of supporting the second lower panel 113.

For example, a plurality of first cooling units 110 may be provided. For example, as shown in FIG. 4, the first cooling units 110 may be positioned to be symmetrical to each other with one on one side of the support frame 130 and one on the other side of the support frame 130. Each first cooling unit 110 may support and cool one or more solar cells C.

For example, one first cooling unit 110 may support and cool a plurality of solar cells C. For example, one first cooling unit 110 may support and cool two or more solar cells C and wires W and wire jigs J corresponding to the solar cells C on the top surface thereof.

The stage 100 may further include a discharge flow path 140. The discharge flow path 140 is positioned inside the stage 100 and may discharge air, which is introduced through the lower air inlet 111 and cools the solder, the solar cells C, and the wire W, to the outside of the device. For example, as shown in FIG. 4, the discharge flow path 140 is positioned inside the first lower panel 112 and may communicate with the air supply flow path 1121 and/or the air distribution flow path 1131. When air injection for cooling from the lower air inlet 111 is completed, some of the injected air may be discharged to the outside of the stage 100 while being emitted through the air nozzles 1132, and the remainder may be re-introduced into the air distribution flow path 1131 and then discharged to the outside of the stage 100 through the discharge flow path 140.

With this configuration, since the stage 100 supporting the solar cells C and the wires W performs a function of cooling the solder, the solar cells C, and the wires W, the soldering device 10 can reduce the time required for cooling and curing. In addition, since the soldering device 10 emits air from a surface directly below the solar cells C and the wires W, it is possible to efficiently cool the solder, the solar cells C, and the wires W. In addition, the soldering device 10 can intensively and independently cool the solder, the solar cells C, and the wires W through the second lower panels 113 provided equal in number to the wires W.

The body 200 is positioned to face the stage 100 and may apply heat to the solar cells C and wires W mounted on the stage 100. In detail, the body 200 may heat the solder positioned on the surface of the wire W up to a temperature for melting the solder.

For example, the body 200 may cool the solar cells C and wires W mounted on the stage 100. For example, the body 200 may irradiate the solar cells C and the wires W with light using the heater 300 to melt the solder on the wire W and then emit air to cool the solar cells C and the wires W.

For example, the body 200 may include a second cooling unit 210. For example, the second cooling unit 210 may be positioned inside the body 200 to face a bottom surface of the body 200. For example, the second cooling unit 210 may emit air toward the solder, solar cells C and wires W positioned on the stage 100 to cool the solder, solar cells C and wires W.

For example, the second cooling unit 210 may include upper air inlets 211, a connecting plate 212, a first upper panel 213, and a second upper panel 214.

A plurality of upper air inlets 211 are positioned on one side of the second cooling unit 210 and connected to an air supply source (not shown) from which air is injected. For example, as shown in FIG. 8, the plurality of upper air inlets 211 may be positioned at predetermined intervals in the longitudinal direction of the solar cells C. The air injected into the upper air inlets 211 may be emitted to the solder, the solar cells C, and the wires W through the first upper panel 213 and the second upper panel 214.

For example, two rows of upper air inlets 211 may be positioned at both ends of the solar cell C in a width direction.

The connecting plate 212 is a member that connects the second cooling unit 210 to the body 200 and may have the plurality of upper air inlets 211 positioned on one side and the first upper panel 213 positioned on the other side. For example, as shown in FIG. 8, the connecting plate 212 is a square frame with an empty inner side, and the plurality of upper air inlets 211 may be positioned in two rows on a top surface of the connecting plate 212. Additionally, the first upper panel 213 may be positioned on a bottom surface of the connecting plate 212, and the second upper panel 214 may be positioned below the first upper panel 213.

For example, the connecting plate 212 may have an internal flow path through which the plurality of upper air inlets 211 communicate with the first upper panel 213. The air injected from the upper air inlets 211 may move to the first upper panel 213 through the connecting plate 212.

The first upper panel 213 may be positioned below the connecting plate 212. For example, as shown in FIGS. 8 and 9, both ends of the first upper panel 213 may be positioned on a bottom surface of the connecting plate 212 and connected to a pair of upper air inlets 211 corresponding thereto.

For example, the first upper panel 213 may include air supply ports 2131, an air distribution flow path 2132, and air distribution slits 2133.

The air supply ports 2131 are positioned on one side and the other side of the first upper panel 213 to correspond to the upper air inlets 211. For example, as shown in FIG. 9, the air supply ports 2131 are positioned to correspond to both ends of the air distribution flow path 2132, and the upper air inlet 211 communicates with the air distribution flow path 2132 through the air supply ports 2131.

The air distribution flow path 2132 is a groove in a bottom surface of the first upper panel 213 and extends in a longitudinal direction of the first upper panel 213, and both ends of the air distribution flow path 2132 are connected to the air supply ports 2131. The air distribution flow path 2132 is connected to a plurality of air distribution slits 2133 to distribute the air introduced through the air supply ports 2131 to the air distribution slits 2133. Additionally, the air distribution flow path 2132 may extend in a direction perpendicular to a direction of movement of the solar cells C and the wires W, i.e., in the width direction of the solar cells C.

For example, the air distribution flow path 2132 may overlap a plurality of air nozzles 2141 of the second upper panel 214. As shown in FIG. 9, the air distribution flow path 2132 overlaps some of a plurality of rows of air nozzles 2141, and thus some of the air introduced into the air distribution flow path 2132 may move to the air distribution slits 2133, and the remainder may be emitted through the overlapped air nozzles 2141 below the air distribution flow path 2132.

A plurality of air distribution slits 2133 are positioned on the bottom surface of the first upper panel 213 and extend from one side and the other side of the air distribution flow path 2132. The air distribution slits 2133 distribute the air introduced into the air distribution flow path 2132 in various directions such that the air is emitted to the plurality of air nozzles 2141. For example, as shown in FIG. 9, the air distribution slits 2133 may extend in a direction perpendicular to the air distribution flow path 2132 and correspond to the plurality of air nozzles 2141 positioned below the air distribution slits.

For example, the air distribution slit 2133 may have a smaller depth than the air distribution flow path 2132. Since the air distribution slit 2133, through which air is introduced at a smaller flow rate than the air distribution flow path 2132, has a smaller depth than the air distribution flow path 2132, elements required for processing can be reduced. In particular, it is possible to prevent the air introduced from the air distribution flow path 2132 from oscillating in the air distribution slit 2133 and forming a vortex.

The second upper panel 214 is positioned below the first upper panel 213 and may include the plurality of air nozzles 2141. For example, as shown in FIG. 9, the second upper panel 214 is a plate-shaped member positioned below the first upper panel 213 and may include a plurality of rows of air nozzles 2141. The air nozzles 2141 may be positioned to correspond to the air distribution flow path 2132 and the air distribution slits 2133. Accordingly, the air injected into the upper air inlet 211 may be emitted to the solar cells C and the wires W through the air supply ports 2131, the air distribution flow path 2132, the air distribution slits 2133, and the air nozzles 2141.

For example, one air distribution slit 2133 may correspond to the plurality of air nozzles 2141. For example, one air distribution slit 2133 may correspond to two or more air nozzles 2141.

For example, the plurality of air nozzles 2141 may be positioned to form a plurality of rows. As shown in FIG. 7, the plurality of air nozzles 2141 may be spaced an interval L2 from each other in one direction, for example, in the width direction of the solar cell C, to form one row. Additionally, the rows of the plurality of air nozzles 2141 may be spaced an interval W2 from each other in the direction of movement of the solar cells C and the wires W.

Here, the interval L2 and the interval W2 may vary depending on the size of the solar cell C. For example, the interval L2 may be in the range of 5% to 15% of the width of the solar cell C (in a direction perpendicular to the direction of movement of the solar cells C and the wires W). When the interval L2 is less than 5% of the width of the solar cell C, the number of the air nozzles 2141 included in one row becomes too great, and thus the pressure of the air emitted from the air nozzles 2141 may be insufficient and interference may occur between adjacent air nozzles 2141. In addition, when the interval L2 exceeds 15% of the width of the solar cell C, the interval between the air nozzles 2141 becomes too great, and thus it is difficult to uniformly cool the solar cells C and the wires W.

Additionally, the interval W2 may be in the range of 10% to 20% of the length of the solar cell C (in the direction of movement of the solar cells C and the wires W). When the interval W2 is less than 10% of the length of the solar cell C, the total number of the air nozzles 2141 becomes too great, and thus the pressure of the air emitted from the air nozzles 2141 may be insufficient and interference may occur between adjacent rows of the air nozzles 2141. In addition, when the interval W2 exceeds 20% of the length of the solar cell C, the interval between the rows of the air nozzles 2141 becomes too great, and thus it is difficult to uniformly cool the solar cells C and the wires W.

For example, the plurality of air nozzles 2141 may be positioned between the heaters 300. For example, as shown in FIGS. 6 and 7, the rows of the plurality of air nozzles 2141 and the heaters 300 may be alternately positioned in the direction of movement of the solar cells C and the wires W. As a result, a region cooled by the body 200 and a region irradiated with light by the heater 300 overlap, and thus the soldering device 10 can be formed to be compact and the curing process can be performed efficiently.

For example, the plurality of air nozzles 1132 provided in the first cooling unit 110 and the plurality of air nozzles 2141 provided in the second cooling unit 210 are spaced apart from each other in different directions. For example, as shown in FIG. 5, the plurality of air nozzles 1132 may be spaced apart from each other in one second lower panel 113 in a row in a direction of transport of the wires W. On the other hand, as shown in FIG. 7, the plurality of air nozzles 2141 may be spaced apart from each other in one second upper panel 214 in a row in a direction perpendicular to the direction of transport of the wires W.

For example, the plurality of air nozzles 1132 provided in the first cooling unit 110 and the plurality of air nozzles 2141 provided in the second cooling unit 210 may not overlap each other. That is, the air nozzles 2141 may be positioned between the adjacent air nozzles 1132 such that the cooling regions formed by the air nozzles 1132 and the air nozzles 2141 do not overlap each other. This configuration can improve cooling efficiency.

For example, the body 200 may cool the plurality of solar cells C and the wires W corresponding to the solar cells C. For example, as shown in FIG. 6, the body 200 may include a plurality of second cooling units 210 (e.g., four), and each second cooling unit 210 may include a pair of the first upper panel 213 and the second upper panel 214. Additionally, the pair of the first upper panel 213 and the second upper panel 214 may have a size corresponding to one solar cell C.

The heater 300 is located on one side of the body 200 and irradiates the solar cells C and the wires W, which is coated with the solder, with light of a specific wavelength to melt the solder. For example, the heater 300 is an ultraviolet lamp that irradiates the solder applied to the wires W with ultraviolet rays to melt the solder. The plurality of heaters 300 may be positioned apart from each other in the longitudinal direction of the solar cells C. Alternatively, the heater 300 may apply heat at a predetermined temperature to melt the solder applied to the wires W.

Although the present invention has been described with reference to embodiments illustrated in the drawings, these are merely examples. Those skilled in the art will fully appreciate that various modifications and other equivalent embodiments are possible from the embodiments. Therefore, the true technical protection scope of the present invention should be determined based on the appended claims.

The specific technical content described in the embodiments is only an example and does not limit the technical scope of the embodiments. In order to describe the invention concisely and clearly, description of general techniques and configurations of the related art may be omitted. Additionally, the connection or absence of connection of lines between components shown in the drawings is merely an example of functional connections and/or physical or circuit connections and may be expressed in an actual device by various alternative or additional functional connections, physical connections, or circuit connections. Additionally, a component for which there is no specific mention such as "essential" or "importantly" may not be an absolutely necessary component for the application of the present invention.

The terms "above," "the," and a similar designators used in the description and claims of the invention may refer to both the singular and the plural, unless specifically limited. In addition, when a range is described in an embodiment, it is considered that the present invention includes an invention to which an individual value belonging to the range is applied (unless otherwise described), and it is the same as describing each individual value constituting the range in the description of the invention. Additionally, when there is no explicit description or contradiction regarding a sequence of steps constituting a method according to an embodiment, the steps may be performed in any suitable order. The embodiments are not necessarily limited to the sequence in which the above steps are described. The use of any examples or exemplary terms (e.g., "for example," "etc.") in the embodiments is merely intended to describe the embodiments in detail and does not limit the scope of the embodiments by virtue of such examples or exemplary terms, unless otherwise limited by the claims. Additionally, a person skilled in the art will appreciate that various modifications, combinations, and changes can be made according to design conditions and factors within the scope of the appended claims or their equivalents.

### [Industrial Applicability]

The present invention can be used in industries relating to a soldering device and a tabbing apparatus including the same.

## Claims

1. A soldering device comprising:
a stage that supports a solar cell and a wire;
a body that faces the stage; and
a plurality of heaters that are positioned on a bottom surface of the body to face the solar cell and the wire,
wherein the stage includes a first cooling unit positioned in a region corresponding to bottom surfaces of the solar cell and wire mounted on the stage.

2. The soldering device of claim 1, wherein, when the plurality of heaters irradiate the solar cell and wire mounted on the stage with light, the stage emits air from the first cooling unit at a position at which the stage faces the plurality of heaters or at a position at which the stage does not overlap the plurality of heaters to cool the solar cell and the wire.

3. The soldering device of claim 2, wherein the first cooling unit includes:
a lower air inlet;
a first lower panel that has a flow path through which air is introduced from the lower air inlet; and
a second lower panel that has a top surface on which the solar cell and the wire are mounted, an air distribution flow path communicating with the flow path of the first lower panel, and a plurality of air nozzles communicating with the air distribution flow path and emitting air toward the solar cell and the wire.

4. The soldering device of claim 3, wherein the first cooling unit is positioned with the same number and interval to correspond to a plurality of wires mounted on the stage.

5. The soldering device of claim 1, further comprising a second cooling unit that is positioned on the bottom surface of the body and emits air toward the solar cell and wire mounted on the stage.

6. The soldering device of claim 5, wherein the second cooling unit includes:
an upper air inlet;
a first upper panel having a flow path through which air is introduced from the upper air inlet; and
a second upper panel that is positioned on a bottom surface of the first upper panel and includes a plurality of air nozzles communicating with the flow path.

7. The soldering device of claim 6, wherein the plurality of air nozzles are positioned alternately with the plurality of heaters in one direction.

8. The soldering device of claim 6, wherein the first upper panel includes:
a pair of air supply ports corresponding to the upper air inlet;
an air distribution flow path that is formed on the bottom surface of the first upper panel and communicates with the pair of air supply ports; and
a plurality of air distribution slits that extend from the air distribution flow path and overlap the plurality of air nozzles of the second upper panel.

9. The soldering device of claim 5, wherein a plurality of air nozzles provided in the first cooling unit and a plurality of air nozzles provided in the second cooling unit are spaced apart from each other in different directions.

10. A tabbing apparatus comprising:
a solar cell supply device that supplies a solar cell;
a wire transport device that is spaced apart from the solar cell supply device and supplies a plurality of wires;
a wire jig transport device that is spaced apart from the solar cell supply device and the wire transport device and supplies a wire jig which supports the solar cell and the wires;
a moving device that supplies the solar cell and the wire jig onto the wires arranged on the wire transport device; and
a soldering device that allows the solar cell and the wire jig to be mounted on the wires and then solders the solar cell and the wires,
wherein the soldering device is the soldering device according to any one of claims 1 to 9.

11. The tabbing apparatus of claim 10, further comprising a dipping unit that coats or plates the plurality of wires with solder and supplies the wires to the wire transport device.
